# EUROPÄISCHE PATENTSCHRIFT

(11) **EP 0 660 264 B1**
(45) Veröffentlichungstag und Bekanntmachung des Hinweises auf die Patenterteilung: **13.10.1999**
(21) Anmeldenummer: 94119202.3
(22) Anmeldetag: 06.12.1994
(51) Int. Cl.: G06M 1/27, G06M 1/272, G01D 5/34, G01D 5/24, G01F 15/06, G01R 11/16

(54) **Verfahren zum elektrischen Auslesen eines mehrstelligen Rollenzählwerks für ein Volumenmessgerät oder für einen Elektrizitätszähler**
Method for providing electrical signal readout of a multi-digit drum-counter for use in a flow or electricity-meter
Procédé pour lire les position des roues d'un compteur à rouleaux à plusieurs cliffres pour des compteurs de débit ou d'électricité

(30) Priorität: 23.12.1993 CH 385393
(43) Veröffentlichungstag der Anmeldung: 28.06.1995
(73) Patentinhaber: GWF Gas- & Wassermesserfabrik AG, CH-6002 Luzern (CH)
(72) Erfinder: Mettler, Roland Dipl. Phys. ETH, CH-6010 Kriens (CH)
(74) Vertreter: Blöchle, Hans

(56) Entgegenhaltungen:
- US-A- 4 031 386

## Beschreibung

Es sind Volumenmessgeräte für Gas und Wasser wie auch Elektrizitätszähler zur Messung der durchgeströmten Energie bekannt, in welchen das gemessene Volumen respektive die gemessene Energie mit einer dem Messgerät angepassten Untersetzung auf ein mechanisches Rollenzählwerk übertragen wird. Das Rollenzählwerk zeigt dabei die seit der letzten Nullstellung respektive die seit der Inbetriebnahme durchgeflossene Menge an. Zur Bestimmung des Verbrauchs während einer bestimmten Periode wird der Stand des Rollenzählwerkes zu Beginn und am Ende dieser Periode abgelesen. Eine bevorzugte Ausführung für das Rollenzählwerk besteht aus einer Achse, auf welcher die Zahlenrollen drehbar angebracht sind und auf deren Umfang die Ziffern 0 bis 9 aufgebracht sind, sowie aus einer zweiten Achse mit darauf drehbaren Schaltritzeln derart, dass jeweils die kleinerwertige Zahlenrolle im letzten Zehntel einer Umdrehung über das zugeordnete Schaltritzel die nächst höherwertige Rolle um eine Zehntelumdrehung weiterschaltet. Ein Rollenzählwerk für ein Messgerät für Wasser findet sich zum Beispiel in der DE 22 44 404 A1. Je nach Ausführung des Messgerätes ist es zur Erzielung eines grossen Messbereichs mit einer guten Messgenauigkeit wichtig, das zum Antrieb des Rollenzählwerkes erforderliche Drehmoment möglichst klein zu halten.

Aus der US-A- 3 732 404 ist eine Lösung zur elektronischen Auslesung eines Zählwerkes bekannt, in welcher die kontinuierliche Drehbewegung der Zahlenrollen in eine schnappende Bewegung übersetzt wird. Dazu ist sicherzustellen, dass die für die schnappende Bewegung verwendete Feder o.ä. genügend Energie aufnimmt, um das ganze Rollenpaket eine Stellung vorwärts zu drehen, beispielsweise von 19999 auf 20000. Aus der EP 202722 B1 ist eine Lösung bekannt, welche die elektronische Auslesung für ein Zählwerk vom Nadeltyp unter der Verwendung von mechanischen Kontakten ohne Schnappbewegung erlaubt. Natürlich ist es auch möglich, ein Zählwerk vom Nadeltyp im Gleichlauf zu einem Zählwerk mit Rollenzählwerk einzusetzen.

Zum elektronischen Auslesen eines Rollenzählwerks geeignete Drehwinkelsensoren sind bekannt. Ein anderer geeigneter Drehwinkelsensor umfasst mit den auszulesenden Zahlenrollen verbundene Drehkondensatoren mit zugehöriger Auswerteelektronik.

US-A-4,031,386 beschreibt einen Sensor, bei dem die Stellung jeder einzelnen Rolle über optische Sensoren ermittelt wird.

Ein leichtgängiges Rollenzählwerk mit niedrigem Antriebsdrehmoment hat zwischen den einzelnen Zahlenrollen ein gewisses mechanisches Drehspiel, welches sich über mehrere Zahlenrollen zu einem grossen Drehwinkel summieren kann, wenn die Zahlenrollen über das Schaltritzel im Eingriff sind. Nicht im Schalteingriff befindliche Rollen werden in ihrer Stellung bis auf ein kleines Spiel durch das zugehörige Schaltritzel fixiert. Das Drehspiel zwischen im Schalteingriff befindlichen Zahlenrollen einerseits und die Fixierung der nicht im Eingriff befindlichen Zahlenrollen anderseits führt dazu, dass für mehrstellige Rollenzählwerke aus dem momentanen Drehwinkel einer Zahlenrolle nicht in allen Fällen sicher die angezeigte Ziffer auf der entsprechenden Zahlenrolle erkannt werden kann.

Der vorliegenden Erfindung liegt die Aufgabe zugrunde, ein vorzugsweise mit einer elektronischen Schaltung zu realisierendes Verfahren anzugeben, nach welchem die Sensorinformationen eines Rollenzählwerkes mit einem an sich beliebigen Drehwinkelsensor pro auszulesende Zahlenrolle derart ausgewertet werden können, dass ohne einschränkende Bedingungen an die Drehbewegung des Rollenzählwerkes der Anzeigestand des Rollenzählwerkes bei jeder Stellung desselben zuverlässig ermittelt werden kann. Die vorliegende Erfindung hat den Vorteil, dass der Anzeigestand eines Rollenzählwerkes in einem Messgerät mit möglichst einfachen Mitteln zu einem beliebigen Zeitpunkt digital elektronisch ausgelesen werden kann, ohne dass durch die dazu notwendigen Mittel das zum Antrieb des Rollenzählwerkes erforderliche Drehmoment wesentlich verändert wird.

Erfindungsgemäss wird deshalb die Auswertung der Sensorinformationen derart vorgenommen, dass in einem ersten Schritt die Zahlenrollen im Schalteingriff von den fixierten Zahlenrollen unterschieden werden, und dass in einem zweiten Schritt für die im Schalteingriff befindlichen Zahlenrollen deren Anzeige aus dem Drehwinkel einer Zahlenrolle und aus der relativen Verdrehung benachbarter Zahlenrollen ermittelt wird. Vorzugsweise wird die Anzeige der niedrigstwertigen, hintersten Zahlenrolle aus deren Drehwinkel ermittelt und die Anzeige der höherwertigen Zahlenrollen aus der relativen Verdrehung zur jeweils niederwertigeren Zahlenrolle ermittelt. In einem dritten Schritt wird die Anzeige der fixierten Zahlenrollen ermittelt.

In den folgenden Abschnitten wird eine bevorzugte Variante des Verfahrens zur Bestimmung der im Schalteingriff befindlichen Rollen und zur Bestimmung von deren Anzeige im Detail beschrieben. Es zeigen:

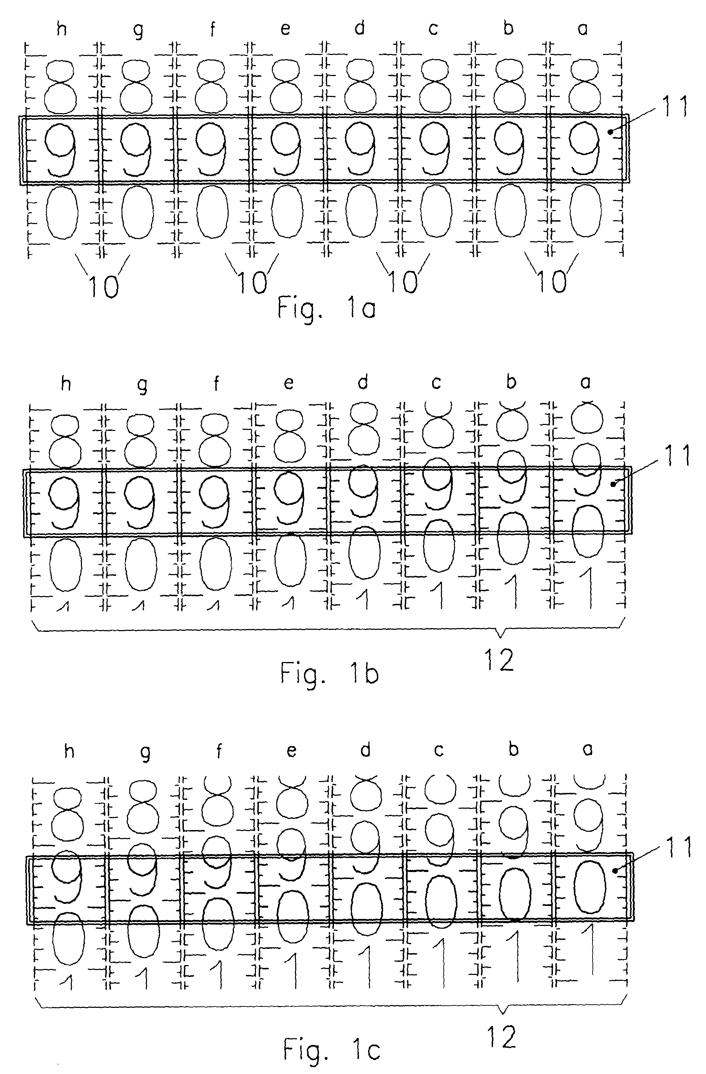

- Figur 1 :: Ein achtstelliges Rollenzählwerk in Vorwärtsdrehung von "99999999" auf "00000000"
Fig. 1 a : Beginn der Drehung.
Fig. 1 b : Drehung der niedrigstwertigen Zahlenrolle um 18 °.
Fig. 1 c : Drehung der niedrigstwertigen Zahlenrolle um 36 °.
- Figur 2 :: Achtstelliges Rollenzählwerk in Rückwärtsdrehung von "00000000" auf "99999999"

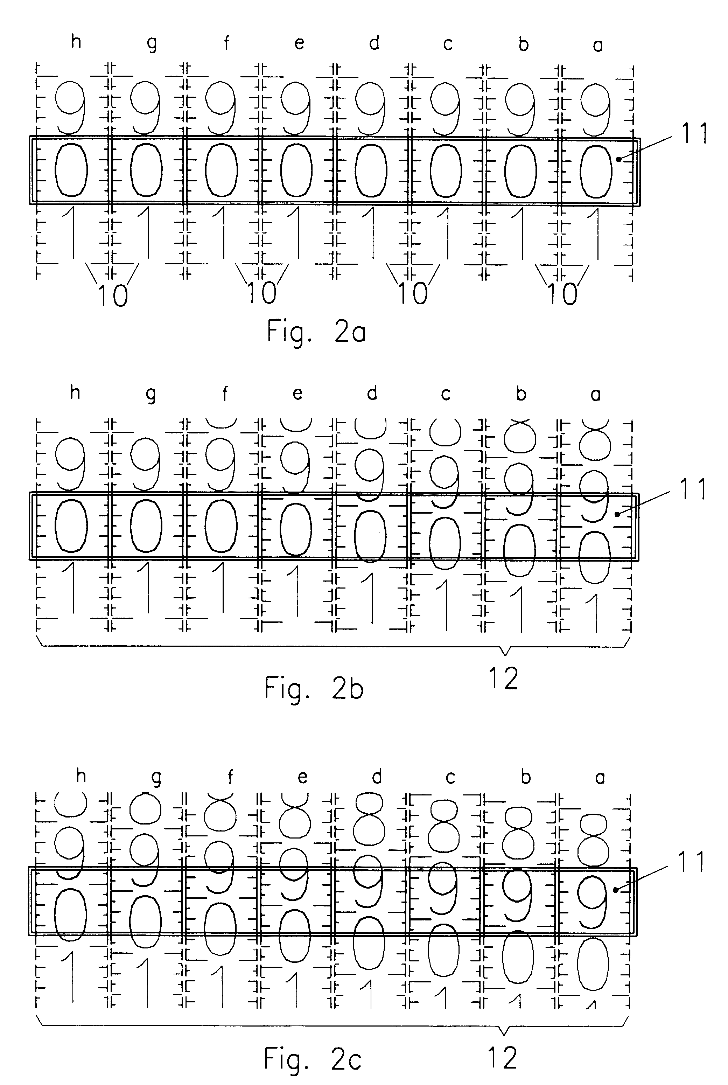

Fig. 2 a : Beginn der Drehung.
Fig. 2 b : Drehung der niedrigstwertigen Zahlenrolle um 18 °.
Fig. 2 c : Drehung der niedrigstwertigen Zahlenrolle um 36 °.

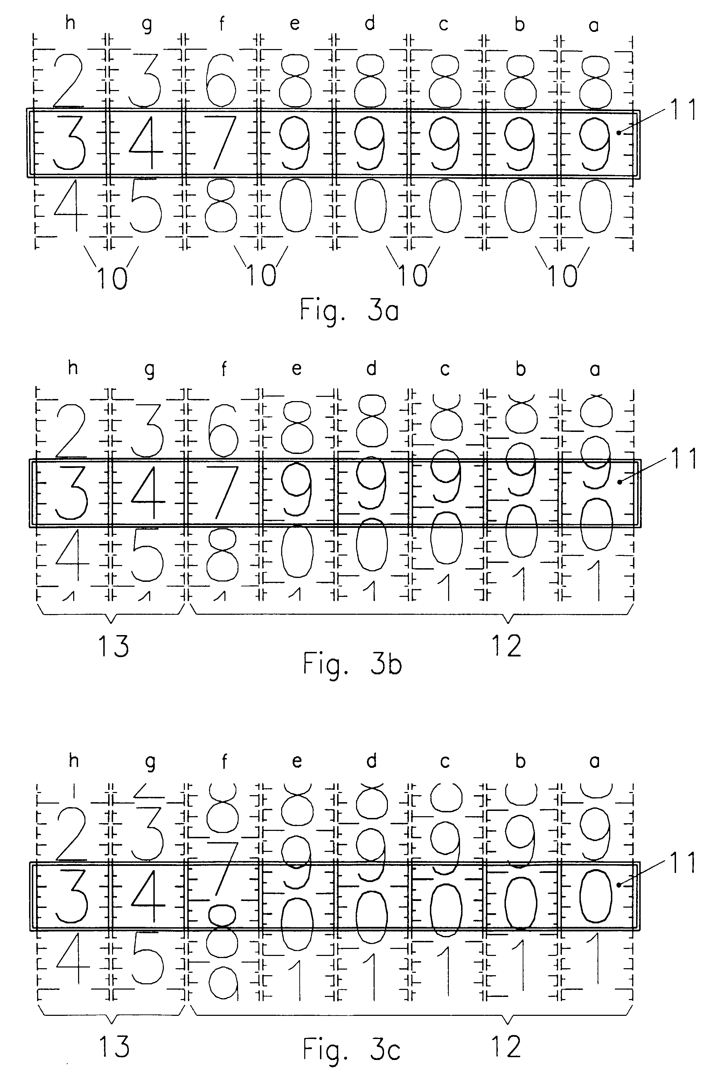

- Figur 3 :: Achtstelliges Rollenzählwerk in Vorwärtsdrehung von "34799999" auf "34800000"
Fig. 3 a : Beginn der Drehung.
Fig. 3 b : Drehung der niedrigstwertigen Zahlenrolle um 18 °.
Fig. 3 c : Drehung der niedrigstwertigen Zahlenrolle um 36 °.

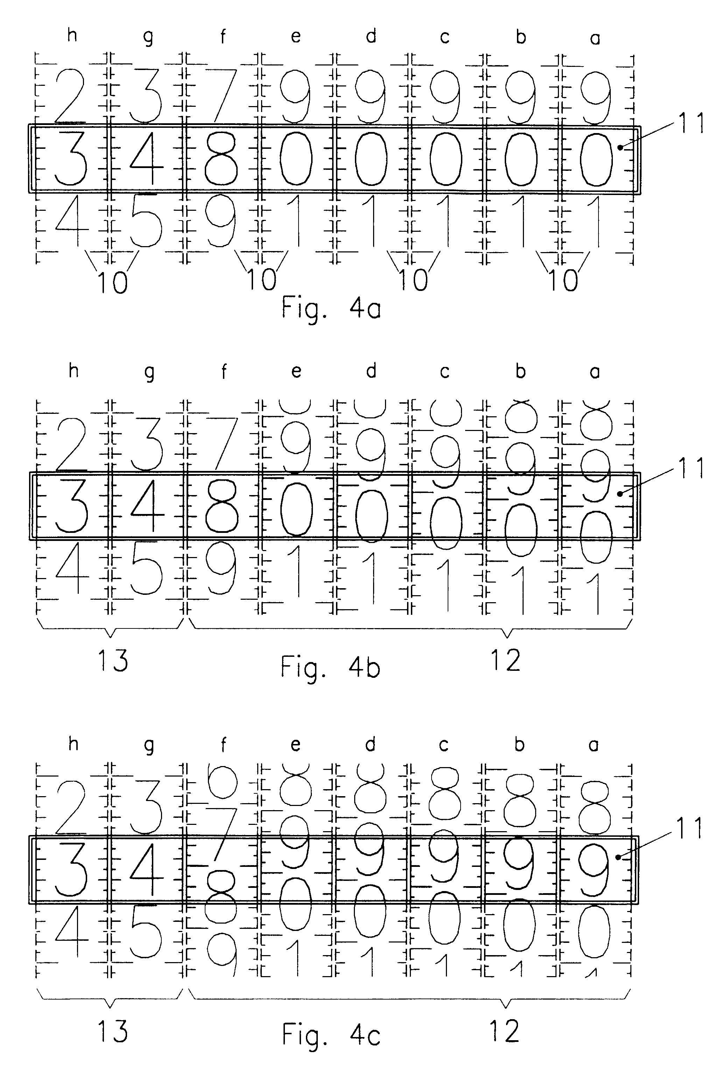

- Figur 4 :: Achtstelliges Rollenzählwerk in Rückwärtsdrehung von "34800000" auf "34799999"
Fig. 4 a : Beginn der Drehung.
Fig. 4 b : Drehung der niedrigstwertigen Zahlenrolle um 18 °.
Fig. 4 c : Drehung der niedrigstwertigen Zahlenrolle um 36 °.

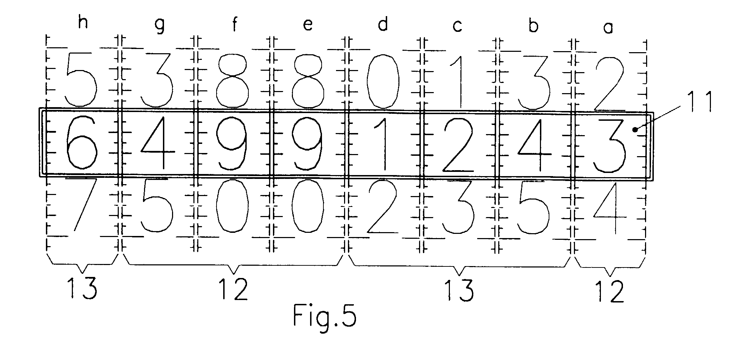

- Figur 5 :: Achtstelliges Rollenzählwerk in Stellung "64991243".

Ein herkömmliches achtstelliges Rollenzählwerk weist acht Zahlenrollen 10 auf, die mit a bis h bezeichnet sind. Mit a ist die niedrigstwertige und mit h die höchstwertige Rolle 10 gemeint. Die Rollen sind durch eine Blende 11 visuell ablesbar, können aber auch durch einen Encoder, wie er in der am gleichen Tag eingereichten Anmeldung EP-A-660,263 "Mehrstelliges Rollenzählwerk für ein Volumenmessgerät" beschrieben ist, ausgelesen werden. In der erwähnten Anmeldung ist auch die an sich bekannte Funktionsweise eines konventionellen Rollenzählwerks beschrieben.

Beim erfindungsgemässen elektronischen Auslesen eines solchen Zählwerks wird zwischen zwei verschiedenen Drehstellungsbereichen einer Zahlenrolle 10 unterschieden, ein Bereich erstreckt sich auf die eindeutig ablesbaren Stellungen von "0" bis "9" und der andere Bereich auf die Stellungen zwischen "9" und "0", in der sich eine Zahlenrolle jeweils im Dreheingriff mit der nächst höherwertigen Zahlenrolle 10 befindet.

Zum Zeitpunkt der Auslesung wird das Rollenzählwerk abhängig von dessen Stellung funktional in mehrere Rollenpakete 12, 13 aufgeteilt. Die Rollenpakete 12 umfassen eine oder mehrere unmittelbar hintereinanderliegende Zahlenrollen 10, die sich gerade mit der nächst höheren in Dreheingriff befinden, sowie diese nächst höherwertige Zahlenrolle. Das heisst z.B. die niedrigstwertige Zahlenrolle a, sowie die nächst höherwertige Zahlenrolle b, falls die niedrigstwertige Zahlenrolle a in der Stellung zwischen "9" und "0" ist, sowie wiederum die nächst höherwertige Zahlenrolle c, falls die zweitniedrigstwertige in der Stellung zwischen "9" und "0" ist, und so weiter bis und mit einer Zahlenrolle 10, welche nicht in der Stellung zwischen "9" und "0" ist oder bis zur höchstwertigen Zahlenrolle des Rollenzählwerkes. Die Rollenpakete 12 werden hier als "drehend" bezeichnet, wenngleich im Moment der Ablesung nicht alle bzw. bei gerade stehendem Zählwerk gar keine Zahlenrolle 10 sich drehen muss. Die niedrigstwertige Zahlenrolle a wird stets als drehend betrachtet.

Ein stehendes Rollenpaket 13 umfasst alle anderen Zahlenrollen 10. Es können gleichzeitig mehrere Rollenpakete 13 mit jeweils mindestens einer Zahlenrolle 10 auftauchen.

Die in den Figuren 1 und 2 gezeigten Beispiele zeigen Rollenzählwerke mit jeweils nur einem drehenden Rollenpaket 12, bei dem sich alle acht Zahlenrollen 10 in Dreheingriff befinden. Die Beispiele der Figuren 3 und 4 zeigen jeweils ein Rollenpaket 12 und ein stehendes Rollenpaket 13.

Bei der Stellung des Zählwerks in Figur 5 bilden sich vier Rollenpakete aus. Die Zahlenrolle a wird als niedrigstwertige immer als einem drehenden Rollenpaket 12 zugehörig betrachtet. Die Zahlenrollen b, c und d sind ein stehendes Rollenpaket 13. Die Zahlenrollen e, f und g bilden wiederum ein drehendes Rollenpaket 12 und die Zahlenrolle h schliesslich stellt ein stehendes Rollenpaket 13 dar.

Eine nicht gezeigte Schaltung zur Bestimmung der momentanen Anzeige des Rollenzählwerkes ermittelt im drehenden Rollenpaket 12 die Anzeige einer Zahlenrolle 10 aus deren Drehwinkel absolut. Falls das drehende Rollenpaket 12 mehr als eine Zahlenrolle 10 umfasst, ermittelt die Schaltung die Anzeige der anderen Zahlenrollen 10 im Rollenpaket 12 durch deren Verdrehung zur absolut bestimmten Zahlenrolle 10 respektive durch die Verdrehung zu einer vorgängig bestimmten Zahlenrolle 10.

Es sei s als höchstwertige Rolle im Schalteingriff zu bestimmen. Das Verfahren weist folgende Schritte auf: Setze s = a. Wenn Anzeige von a im Bereich "9" bis "0" ist, dann setze s = b. Wenn s = b und absoluter Betrag von Drehwinkel von b minus Drehwinkel von a kleiner als 18 ° ist, dann setze s = c. Wenn s = c und absoluter Betrag von Drehwinkel von c minus Drehwinkel von b kleiner als 18 ° ist, dann setze s = d. Wenn s = d und absoluter Betrag von Drehwinkel von d minus Drehwinkel von c kleiner als 18 ° ist, dann setze s = e. Wenn s = e und absoluter Betrag von Drehwinkel von e minus Drehwinkel von d kleiner als 18 ° ist, dann setze s = f. Wenn s = f und absoluter Betrag von Drehwinkel von f minus Drehwinkel von e kleiner als 18 ° ist, dann setze s = g. Wenn s = g und absoluter Betrag von Drehwinkel von g minus Drehwinkel von f kleiner als 18 ° ist, dann setze s = h. Damit ist s als höchstwertige Zahlenrolle im Schalteingriff bestimmt.

Im folgenden Schritt wird die Anzeige der im Schalteingriff befindlichen Zahlenrollen ermittelt.
Setze Anzeige von a = Drehwinkel von a modulo 10. Für alle Zahlenrollen x für x grösser a und x kleiner oder gleich s setze Anzeige von x = Drehwinkel von x minus Drehwinkel von (x-1) modulo 10 plus Anzeige von niederwertigem Nachbar von x modulo 10. Für die restlichen Zahlenrollen wird vorzugsweise ein analoges Verfahren gewählt.

Auch bei nur geringer Messgenauigkeit des Drehwinkels und grossem Drehspiel der Zahlenrollen (10) kann das Zählwerk noch ausreichend genau ausgelesen werden, wenn zwischen Drehwinkeln kleiner und grösser als +/- 18° unterschieden wird. Ein Drehwinkel bis zu +/- 18° wird dann in Vorwärtsdrehrichtung als Anzeige "9" und in Rückwärtsdrehrichtung als Anzeige "0" gelesen. Ein Drehwinkel über 18° wird in Vorwärtsdrehrichtung als Anzeige "0" und in Rückwärtsdrehrichtung als Anzeige "9" gelesen.

Die Stellung der stehenden Zahlenrollen 10 bzw. Rollenpakete 13 wird am besten durch Ermittlung des absoluten Drehwinkels bestimmt. Das heisst beispielsweise ein Drehwinkel von 1° bis 36° entspricht der Anzeige "1", ein Drehwinkel von 37° bis 72° entspricht der Anzeige "2" usw., bis zu einem Drehwinkel von 325° bis 360°, der der Anzeige "0" entspricht.

## Patentansprüche

1. Verfahren zum Erkennen der Stellung der Zahlenrollen mit einer elektronischen Schaltung für die Ermittlung der momentanen Anzeige des Rollenzählwerkes in einem mehrstelligen Rollenzählwerk für ein Volumenmessgerät für Gas oder Wasser oder für einen Elektrizitätszähler, in welchem von jeweils zwei Zahlenrollen die höherwertige Zahlenrolle von der niederwertigen im letzten Zehntel deren Umdrehung über ein Schaltritzel um eine Zehntelumdrehung weitergedreht wird, mit Drehwinkelsensoren zur Erzeugung von Signalen, **dadurch gekennzeichnet,** dass die Schaltung das Rollenzählwerk abhängig von dessen Stellung zum Zeitpunkt der Auslesung funktional in drehende und stehende Rollenpakete (12, 13) aufteilt, beginnend mit einem drehenden Rollenpaket (12), welches die niedrigstwertige Zahlenrolle (a) umfasst, sowie die nächst höherwertige Zahlenrolle (b), falls die niedrigstwertige Zahlenrolle (a) in der Stellung zwischen "9" und "0" ist, sowie wiederum die nächst höherwertige Zahlenrolle (c), falls die zweitniedrigstwertige (b) in der Stellung zwischen "9" und "0" ist, und so weiter bis und mit einer Zahlenrolle (10), welche nicht in der Stellung zwischen "9" und "0" ist oder bis zur höchstwertigen Zahlenrolle (10) des Rollenzählwerkes, und, falls die höchstwertige Zahlenrolle (10) noch nicht erreicht ist, weitergehend mit einem stehenden Rollenpaket (13), welches die nächst höherwertige Zahlenrolle (10) umfasst, falls diese nicht in der Stellung zwischen "9" und "0" ist, sowie wiederum die nächst höherwertige Zahlenrolle (10), falls auch diese nicht in der Stellung zwischen "9" und "0" ist, und so weiter bis und mit einer Zahlenrolle (10), welche in der Stellung zwischen "9" und "0" ist oder bis zur höchstwertigen Zahlenrolle (10) des Rollenzählwerkes, und, falls die höchstwertige Zahlenrolle (10) noch nicht erreicht ist, weitergehend mit einem drehenden Rollenpaket reichend bis und mit einer Zahlenrolle (10), welche nicht in der Stellung zwischen "9" und "0" ist oder bis zur höchstwertigen Zahlenrolle (10) des Rollenzählwerkes, und so fort bis zur höchstwertigen Zahlenrolle (10) des Rollenzählwerkes, und dass die Schaltung zur Bestimmung der momentanen Anzeige des Rollenzählwerkes im drehenden Rollenpaket (12) respektive in den drehenden Rollenpaketen die Anzeige einer Zahlenrolle (10) aus deren Drehwinkel absolut ermittelt und, falls das entsprechende drehende Rollenpaket (12) mehr als eine Zahlenrolle (10) umfasst, die Schaltung die Anzeige der anderen Zahlenrollen (10) im Rollenpaket durch deren Verdrehung zur absolut bestimmten Zahlenrolle (10) respektive durch die Verdrehung zu einer vorgängig bestimmten Zahlenrolle (10) ermittelt.

2. Verfahren zum Erkennen der Stellung der Zahlenrollen nach Anspruch 1, dadurch gekennzeichnet, dass die Schaltung für jedes drehende Rollenpaket (12) die Stellung der niedrigstwertigen Zahlenrolle aus deren Drehwinkel absolut ermittelt und dass die Schaltung die Stellung von höherwertigen Zahlenrollen (10) im jeweiligen drehenden Rollenpaket (12) sukzessive aufsteigend durch deren Verdrehung relativ zur benachbarten niedrigwertigeren Zahlenrolle (10) ermittelt.

3. Verfahren zum Erkennen der Stellung der Zahlenrollen nach Anspruch 2, dadurch gekennzeichnet, dass ein Drehwinkel bis zu +/- 18° in Vorwärtsdrehrichtung als Anzeige "9" und in Rückwärtsdrehrichtung als Anzeige "0" gelesen wird und dass ein Drehwinkel über 18° in Vorwärtsdrehrichtung als Anzeige "0" und in Rückwärtsdrehrichtung als Anzeige "9" gelesen wird.

4. Verfahren zum Erkennen der Stellung der Zahlenrollen nach einem der vorhergehenden Ansprüche, dadurch gekennzeichnet, dass die Schaltung die Anzeige jeder Zahlenrolle (10) in jedem stehenden Rollenpaket (13) aus deren Drehwinkel absolut ermittelt.

## Claims

1. Method for recognition of the setting of the counting wheels with an electronic circuit for ascertaining the instantaneous indication of the counting wheel mechanism in a multidigit counting wheel mechanism, which is for a gas or water meter or for an electricity meter and in which of each two counting wheels the higher digit counting wheel is turned further through one tenth of a revolution, by way of a "carry" pinion, by the lower digit one in the last tenth of its revolution, with rotational angle sensors for the generation of signals, characterised in that the circuit divides the counting wheel mechanism functionally into rotating and stationary wheel packets (12, 13) in dependence on its setting at the instant of the read-out and beginning with a rotating wheel packet (12), which comprises the lowest digit counting wheel (a) as well as the next higher digit counting wheel (b) in case the lowest digit counting wheel (a) is in the setting between "9" and "0" as well as again the next higher digit counting wheel (c) in case the second lowest digit counting wheel (b) is in the setting between "9" and "0" and so on up to and including a counting wheel (10), which is not in the setting between "9" and "0" or up to the highest digit counting wheel (10) of the counting wheel mechanism and, in case the highest digit counting wheel (10) is not yet reached, continuing with a stationary wheel packet (13), which comprises the next higher digit counting wheel (10) in case this is not in the setting between "9" and "0", as well again the next higher digit counting wheel (10) in case this too is not in the setting between "9" and "0" and so on up to and including a counting wheel (10). which is in the setting between "9" and "0" or up to the highest digit counting wheel (10) of the counting wheel mechanism and, in case the highest digit counting wheel (10) is not yet reached, continuing with a rotating wheel packet reaching up to and including a counting wheel (10), which is not in the setting between "9" and "0" or up to the highest digit counting wheel (10) of the counting wheel mechanism and so on up to the highest digit counting wheel (10) of the counting wheel mechanism, and that the circuit for ascertaining the instantaneous indication of the counting wheel mechanism absolutely ascertains in the rotating wheel packet (12) or packets the indication of a counting wheel (10) from its angle of rotation and, in case the corresponding rotating wheel packet (12) comprises more than one counting wheel (10), the circuit ascertains the indication of the other counting wheels (10) in the wheel packet through either their rotation relative to the absolutely ascertained counting wheel (10) or the rotation relative to a previously ascertained counting wheel (10).

2. Method for recognition of the setting of the counting wheels according to claim 1, characterised in that the circuit for each rotating wheel packet (12) absolutely ascertains the setting of the lowest digit counting wheel from its angle of rotation and that the circuit ascertains the setting of higher digit counting wheels (10) successively rising in the respective rotating wheel packet (12) through their rotation relative to the neighbouring lower digit counting wheel (10).

3. Method for recognition of the setting of the counting wheels according to claim 2, characterised in that an angle of rotation up to +/- 18° in forward rotational direction is read as indication "9" and in reverse rotational direction is read as indication "0" and that an angle of rotation more than 18° in forward rotational direction is read as indication "0" and in reverse rotational direction is read as indication "9".

4. Method for recognition of the setting of the counting wheels according to one of the preceding claims, characterised in that the circuit absolutely ascertains the indication of each counting wheel (10) in each stationary wheel packet (13) from its angle of rotation.

## Revendications

1. Procédé pour identifier la position des rouleaux à chiffres à l'aide d'un circuit électronique pour déterminer l'indication momentanée d'un compteur à rouleaux à plusieurs chiffres pour un appareil de mesure volumétrique de gaz ou d'eau ou pour un compteur d'électricité, dans lequel, sur deux rouleaux, celui qui indique la plus faible valeur fait tourner, lors de son dernier dixième de tour, celui qui indique la plus grande valeur d'un dixième de tour par l'intermédiaire d'un pignon d'accouplement, et qui comporte des capteurs d'angle de rotation destinés à générer des signaux,
caractérisé en ce que d'un point de vue fonctionnel, le circuit divise le compteur à rouleaux, en fonction de sa position au moment du relevé, en groupes de rouleaux tournants et fixes (12, 13) : avec pour commencer un groupe de rouleaux tournants (12) qui comprend le rouleau (a) indiquant la valeur la plus faible et le rouleau (b) indiquant la valeur supérieure suivante, au cas où ledit rouleau (a) indiquant la valeur la plus faible est dans la position située entre "9" et "0", ainsi que le rouleau (c) indiquant la valeur supérieure suivante, au cas où le rouleau (b) indiquant la deuxième valeur, par ordre croissant, est dans la position située entre "9" et "0", et ainsi de suite jusqu'à un rouleau (10), inclus, qui ne se trouve pas dans la position située entre "9" et "0" ou jusqu'au rouleau (10) du compteur indiquant la valeur la plus élevée ; puis, au cas où le rouleau (10) indiquant la valeur la plus élevée n'est pas encore atteint, un groupe de rouleaux fixes (13) qui comprend le rouleau (10) indiquant la valeur supérieure suivante, au cas où celui-ci ne se trouve pas dans la position située entre "9" et "0", ainsi que le rouleau (10) indiquant la valeur supérieure suivante, au cas où celui-ci ne se trouve pas lui non plus dans la position située entre "9" et "0", et ainsi de suite jusqu'à un rouleau (10), inclus, qui se trouve dans la position située entre "9" et "0" ou jusqu'au rouleau (10) du compteur qui indique la valeur la plus élevée ; et également, au cas où le rouleau (10) indiquant la valeur la plus élevée n'est pas encore atteint, un groupe de rouleaux tournants qui va jusqu'au rouleau (10), inclus, qui ne se trouve pas dans la position située entre "9" et "0" ou jusqu'au rouleau (10) du compteur qui indique la valeur la plus élevée, et ainsi de suite jusqu'au rouleau (10) du compteur qui indique la valeur la plus élevée,
et en ce que le circuit prévu pour définir l'indication momentanée du compteur à rouleaux dans le ou les groupes de rouleaux tournants (12) détermine d'une manière absolue l'indication d'un rouleau (10) à partir de l'angle de rotation de celui-ci et, au cas où le groupe de rouleaux tournants (12) correspondant comprend plus d'un rouleau (10), le circuit détermine l'indication des autres rouleaux (10) du groupe grâce à leur rotation par rapport au rouleau (10) défini de manière absolue ou grâce à la rotation par rapport à un rouleau (10) défini précédemment.

2. Procédé pour identifier la position des rouleaux à chiffres selon la revendication 1, caractérisé en ce que le circuit prévu pour chaque groupe de rouleaux tournants (12) détermine de manière absolue la position du rouleau indiquant la valeur la plus faible à partir de l'angle de rotation de ce rouleau, et en ce que le circuit détermine successivement, par ordre croissant, la position des rouleaux (10) indiquant des valeurs supérieures, dans le groupe de rouleaux tournants (12), grâce à leur rotation par rapport au rouleau (10) voisin indiquant une valeur inférieure.

3. Procédé pour identifier la position des rouleaux à chiffres selon la revendication 2, caractérisé en ce qu'un angle de rotation allant jusqu'à +/- 18° est lu dans le sens de rotation avant comme indication "9" et dans le sens de rotation arrière comme indication "0", et en ce qu'un angle de rotation supérieur à 18° est lu dans le sens de rotation avant comme indication "0" et dans le sens de rotation arrière comme indication "9".

4. Procédé pour identifier la position des rouleaux à chiffres selon l'une des revendications précédentes, caractérisé en ce que le circuit détermine de manière absolue l'indication de chaque rouleau à chiffres (10) de chaque groupe de rouleaux fixes (13) à partir de son angle de rotation.
